Europäisches Patentamt

(19) European Patent Office

Office européen des brevets

(11) Numéro de publication: **0 090 694**
**B1**

(12) **FASCICULE DE BREVET EUROPEEN**

(45) Date de publication du fascicule du brevet:
03.07.85

(51) Int. Cl.⁴: **H 03 B 9/14**

(21) Numéro de dépôt: **83400505.0**

(22) Date de dépôt: **11.03.83**

(54) Oscillateur accordable en fréquence constitué par une diode oscillatrice et une diode à capacité variable, et procédé d'accord mécanique de cet oscillateur.

(30) Priorité: **23.03.82 FR 8204914**

(43) Date de publication de la demande:
**05.10.83 Bulletin 83/40**

(45) Mention de la délivrance du brevet:
**03.07.85 Bulletin 85/27**

(84) Etats contractants désignés:
**DE GB IT NL**

(56) Documents cités:
**EP - A - 0 005 096**
**EP - A - 0 068 946**
**FR - A - 2 183 016**
**FR - A - 2 392 539**
**US - A - 3 792 374**

**11th EUROPEAN MICROWAVE CONFERENCE,**
**Amsterdam, 7-11 septembre 1981, pages 888-893,**
**Sevenoaks, GB. J. ONDRIA: "Partially integrated**
**electronically tuned millimeter-wave (33-75 GHz) gunn**
**oscillators"**

(73) Titulaire: **THOMSON-CSF, 173, Boulevard Haussmann,**
**F-75379 Paris Cedex 08 (FR)**

(72) Inventeur: **Heitzmann, Michel, THOMSON-CSF**
**SCPI 173, bld Haussmann, F-75379 Paris Cedex 08 (FR)**
Inventeur: **Lelong, Christian, THOMSON-CSF**
**SCPI 173, bld Haussmann, F-75379 Paris Cedex 08 (FR)**

(74) Mandataire: **Taboureau, James et al, THOMSON-CSF**
**SCPI 173, Bld Haussmann, F-75379 Paris Cedex 08 (FR)**

## Description

La présente invention concerne un dispositif électronique oscillant, accordable en fréquence, constitué par un composant unitaire comportant une diode oscillatrice et une diode à capacité variable, monté dans une cavité; elle concerne plus particulièrement les moyens d'accord mécanique de la fréquence d'oscillation d'un oscillateur à ondes millimétriques accordable électriquement en fréquence.

Un émetteur hyperfréquence fonctionnant dans le domaine des ondes millimétriques comprend une diode oscillatrice et une diode à capacité variable, par exemple empilées l'une sur l'autre comme cela a été décrit dans la demande de brevet EP-A 68946 de la demanderesse avec priorité du 19 juin 1981 et publiée le 5.1.83 et placées à l'intérieur d'une cavité. Les deux diodes, sous forme de pastilles, sont séparées par un disque métallique qui sert à la fois d'adaptation radiale d'impédance et de prise de contact pour la polarisation des diodes. Elles sont de plus entourées chacune par un anneau de matériau diélectrique qui sert de cale et de support des connexions sur au moins une face de la diode.

Un émetteur composé d'une diode oscillatrice et d'une diode à capacité variable dans une cavité oscille rarement à la fréquence exacte pour laquelle il a été réalisé.

D'autre part, lorsqu'un émetteur est monté dans un système plus complexe, les variations d'ondes stationnaires entraînent un changement de la fréquence centrale d'oscillation.

Il est donc nécessaire de régler de façon fine et continue la fréquence centrale d'oscillation d'un émetteur, une fois les éléments assemblés dans la cavité.

Les procédés d'accords connus sont de deux types:

— D'ordre mécanique, le changement de diamètre du disque métallique placé entre les deux diodes permet d'adapter l'impédance radiale et équivaut donc à un réglage mécanique de la fréquence centrale d'oscillation.

— D'ordre électrique, le réglage de la polarisation sur la diode à capacité variable permet de faire varier la capacité en série ou en parallèle avec la diode, qui constitue le système oscillant.

La demande de brevet EP-A 68946 déposée par la demanderesse décrit un tel oscillateur et l'émetteur accordable en fréquence comprenant un composant unitaire constitué par une diode oscillatrice et une diode à capacité variable. Dans cette demande de brevet il est prévu que le réglage de la fréquence centrale d'oscillation se fait par ajustage du disque métallique intercalé entre les deux diodes et par le réglage de la tension de polarisation sur la diode à capacité variable. On peut également modifier la hauteur du composant à l'intérieur de la cavité, mais la présence d'un contact latéral, sur le disque métallique intercalé entre les deux diodes, interdit tout réglage continu.

Le réglage continu et fin mis au point au titre de l'invention consiste à modifier l'inductance ou self en série avec la diode à capacité variable, de façon à modifier la fréquence centrale d'oscillation de l'émetteur, en modifiant le diamètre de la tige métallique qui établit le contact sur la diode à capacité variable. Pour cela, la tige de contact de polarisation sur la diode à capacité variable est entourée d'un manchon métallique, en contact mécanique doux avec la tige, et ce manchon est déplacé, par coulissement, jusqu'à ce que la fréquence désirée soit obtenue. Le manchon, qui a obligatoirement un diamètre plus élevé que celui de la tige, fait varier l'inductance de cette connexion électrique dans un rapport direct avec son diamètre. Par conséquent, puisque l'inductance en série avec la diode oscillatrice varie, la fréquence centrale d'oscillation du dispositif varie.

De façon plus précise l'invention consiste en un oscillateur accordable en fréquence, constitué par une diode oscillatrice et une diode à capacité variable assemblées en un composant unitaire monté à l'intérieur d'une cavité, la masse électrique de l'oscillateur étant prise sur l'embase de la diode oscillatrice, la tension de polarisation de la diode oscillatrice étant amenée au moyen d'un premier piston latéral, isolé, qui s'appuie sur un premier disque métallique intercalé entre les deux diodes et en contact électrique avec elles, la tension de polarisation de la diode à capacité variable étant amenée au moyen d'un second piston isolé qui s'appuie sur un second disque métallique qui sert d'embase à la diode à capacité variable, cet oscillateur étant caractérisé en ce qu'il est accordable de façon continue par un moyen mécanique constitué par un manchon métallique, mobile autour du second piston avec lequel il est en contact mécanique doux, le déplacement de ce manchon le long du piston, engendrant une modification du diamètre de cette connexion électrique, engendre une modification de l'inductance en série avec les diodes et permet le réglage de la fréquence centrale d'oscillation.

L'invention sera mieux comprise par la description d'un exemple d'application qui en est faite, cette description s'appuyant sur les figures annexées qui représentent:

— fig. 1: un composant unitaire formant oscillateur selon l'art connu,

— fig. 2: un émetteur accordable monté en cavité, avec accord mécanique fixe et accord électrique selon l'art connu,

— fig. 3: un émetteur accordable monté en cavité avec accord mécanique continu selon l'invention,

— fig. 4: le moyen de réglage continu d'accord selon l'invention.

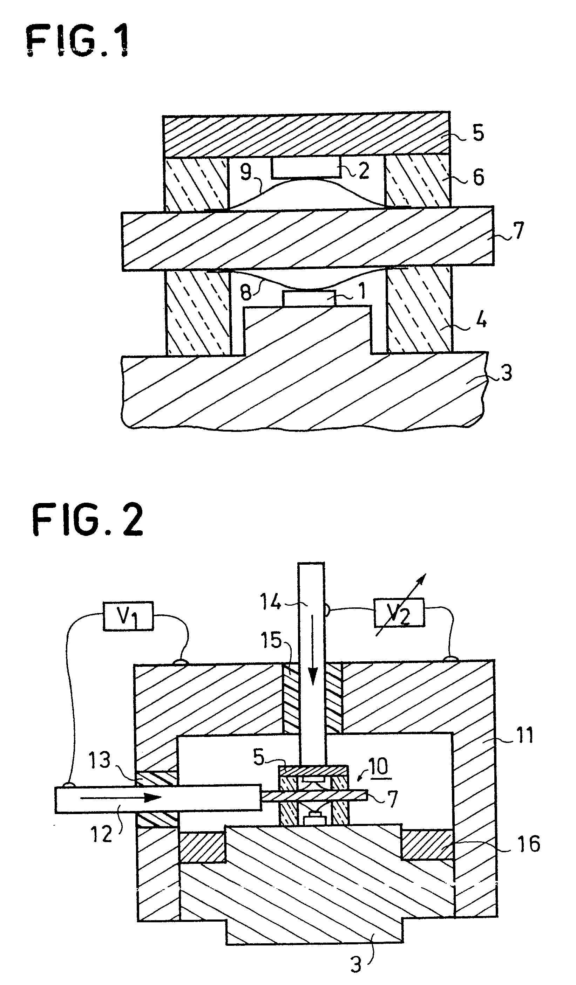

La fig. 1 représente une vue en coupe d'un composant unitaire formant oscillateur selon la demande EP-A 68946.

Un tel émetteur oscillant est essentiellement constitué d'une diode oscillatrice 1 et d'une diode à capacité variable 2, la pastille de la diode oscillatrice 1 est soudée sur une embase métallique 3, qui n'est que partiellement représentée et qui constitue une partie de la cavité, en même temps que la masse électrique. La diode est entourée d'un tube de diélectrique 4. La diode à capacité variable 2 est soudée sur un disque métallique 5, et entourée par un tube de diélectrique 6. Les deux diodes protégées par les deux tubes de diélectrique sont empilées l'une sur l'autre, et l'une face à l'autre, de telle sorte que l'embase 3, le disque métallique 5 et les deux tubes de diélectrique forment l'équivalent d'un boîtier d'encapsulation, qui protège les deux pastilles des deux diodes. Celles-ci qui sont connectées par leur dissipateur thermique à l'embase 3 d'une part et à la plaque 5 d'autre part, sont également connectées à un disque métallique 7, par l'intermédiaire de rubans 8 et 9 respectivement.

Les contacts électriques sont pris sur l'embase 3, directement, et sur les deux pièces métalliques 5 et 7 par l'intermédiaire de pistons de prises de contact.

Il est connu que, au niveau de la pastille semiconductrice de la diode oscillatrice, l'impédance ramenée est liée aux dimensions du piédestal sur lequel elle est soudée, aux dimensions internes de la cavité, au diamètre du disque métallique 7, et à l'épaisseur du tube de diélectrique 4 qui sépare l'embase 3 du disque métallique 7. Par conséquent, un premier procédé d'adaptation radiale de l'impédance consiste à modifier le diamètre du disque 7, et cette modification ne peut être que discontinue, puisque l'ensemble est soudé ou thermocomprimé, et que le réglage de fréquence d'oscillation obtenu par ce moyen ne peut se faire que par l'usinage de disques de diamètres différents.

La fig. 2 représente la vue en coupe et très simplifiée de la partie centrale d'un émetteur accordable monté en cavité, avec accord mécanique fixe et accord électrique, selon l'art connu.

Au centre de la cavité se trouve l'ensemble 10 constitué par le composant unitaire formant émetteur oscillant, décrit en fig. 1. Cet émetteur oscillant est monté sur une embase 3, métallique, qui fait partie de la cavité 11, et qui permet d'introduire le composant unitaire à l'intérieur de la cavité. Un premier piston latéral 12, tenu en place à travers un absorbant hyperfréquence 13, et doté de moyens de déplacement tel qu'un filetage par exemple, assure un premier contact électrique sur la tranche du disque métallique 7 intercalé entre les deux diodes. Un deuxième piston métallique 14, également monté dans un absorbant hyperfréquence 15, assure un second contact électrique sur la pièce métallique 15, sur laquelle est soudée la diode à capacité variable.

Une première tension $V_1$ est appliquée sur la diode oscillatrice par l'intermédiaire de l'embase 3 et du premier piston métallique 12. C'est cette tension $V_1$ qui permet à la diode d'osciller. Une seconde tension $V_2$, variable, est appliquée à la diode à capacité variable par l'intermédiaire de la cavité d'une part et du second piston métallique 14 d'autre part. Selon les cas, mais ceci sort du domaine de l'invention, les deux diodes peuvent être montées en série ou en opposition, l'un ou l'autre montage offrant des avantages par rapport à la polarisation des diodes.

Une première façon d'ajuster la fréquence centrale d'oscillation de ce dispositif consiste à modifier avec une certaine approximation les dimensions intérieures de la cavité résonnante 11 en ajoutant, en collerette autour de l'embase 3, une ou plusieurs pièces métalliques 16, dont l'épaisseur est en liaison directe avec la modification des dimensions internes de la cavité recherchée.

Une seconde façon de régler la fréquence centrale d'oscillation est, comme il a été dit précédemment, de modifier le diamètre de la pièce métallique 7, mais ceci suppose également un usinage de cette pièce, et par conséquent constitue un réglage discontinu.

Une troisième façon de régler la fréquence consiste à agir sur la tension de polarisation variable $V_2$ de la diode à capacité variable: c'est parmi ces trois procédés de réglage le seul qui soit continu et fin.

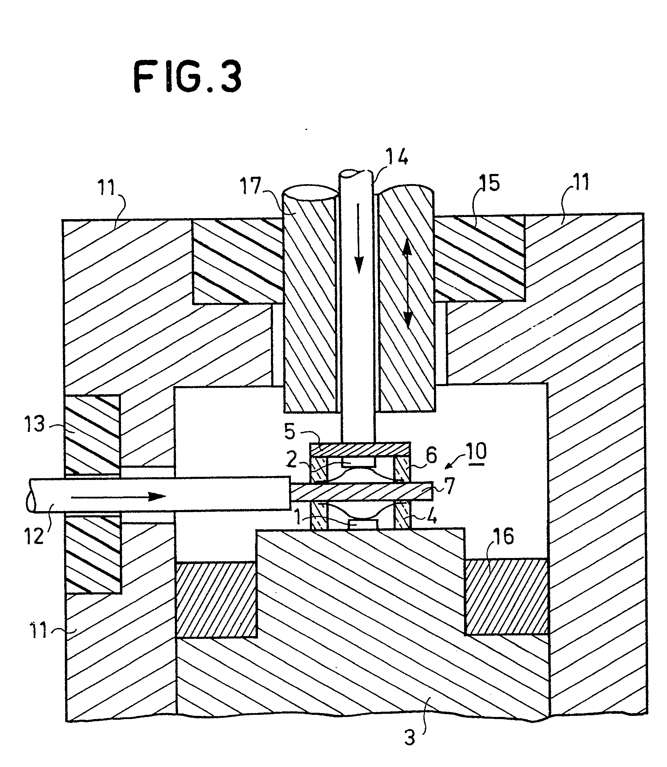

La fig. 3 représente une vue en coupe de la partie centrale de la cavité d'un émetteur accordable, avec accord mécanique continu selon l'invention. Dans le but de simplifier la description, ainsi que la comparaison avec les figures de l'art connu, les mêmes indices de repère désignent les mêmes objets sur cette figure et sur les prédédentes.

L'émetteur accordable comprend donc un composant unitaire constitué d'une diode oscillatrice, protégée par un tube de diélectrique 4, et d'une diode à capacité variable protégée par un tube de diélectrique 6. La masse électrique est prise sur la diode oscillatrice par l'intermédiaire de l'embase métallique 3. La polarisation de la diode oscillatrice est amenée par l'intermédiaire du disque métallique 7 et du piston 12, et la polarisation de la diode à capacité variable est amenée par l'intermédiaire du disque métallique 5 et du piston 14.

Une pièce amovible 16, en cuivre par exemple, lacée autour de l'embase de la diode oscillatrice permet d'ajuster avec une certaine approximation les dimensions intérieures de la cavité. Pour ce faire, on dispose d'un jeu de plusieurs pièces d'épaisseurs variables, ou bien, à partir d'une pièce épaisse, on la rode jusqu'à obtenir une fréquence de l'émetteur qui soit proche de la fréquence recherchée. Cette pièce ainsi que l'embase 3 ont déjà l'avantage d'assurer un bon refroidissement du composant unitaire encapsulé, mais ce n'est qu'une première approche du réglage.

Un réglage plus fin, et continu celui-là, est obtenu au moyen d'un manchon 17 qui coulisse autour du piston 14 de polarisation de la diode à capacité variable. Ce manchon est en contact mécanique doux avec le piston 14, ce qui fait que lorsque le manchon 17 est déplacé le long du piston 14, le diamètre de l'ensemble piston manchon qui établit le contact sur la diode à capacité variable varie lui-même: on introduit ainsi une self série variable et, par conséquent, on modifie la fréquence d'oscillation.

Lorsque le diamètre de cet ensemble est diminué, c'est-à-dire lorsque le manchon est éloigné de la diode à capacité variable, la self augmente et la fréquence diminue.

Au contraire, lorsque le diamètre de cet ensemble est augmenté, c'est-à-dire lorsque le manchon est rapproché de la diode à capacité variable, la self diminue et, par conséquent, la fréquence augmente.

Cet ensemble de prise de contact de polarisation sur la diode à capacité variable est ainsi réalisé: le piston de prise de contact 14 est amené au contact du disque métallique 5, qui supporte la diode à capacité variable, au moyen d'un ressort ou en étant vissé avec précaution pour ne pas endommager le composant unitaire. Par conséquent, le piston 14 est fixe par rapport à l'ensemble de la cavité. Il est entouré par un manchon 17, dont la position est réglable par des moyens qui seront décrits ultérieurement, ce manchon 17 étant supporté et centré par rapport à l'ensemble de cavité 11 au moyen d'une pièce en matériau absorbant les hyperfréquences 15. Pour des raisons de simplification du dessin seules les parties du piston 14 et du manchon 17 qui se trouvent à l'intérieur de la cavité ont été représentées sur la fig. 3. En déplaçant le manchon 17 autour du piston 14, la self varie continuellement: lorsque les diamètres du piston 14 et du manchon 17 sont peu différents, la variation mécanique de fréquence est faible mais la sensibilité est grande. Inversément, lorsque les diamètres de ces deux pièces sont très différents, la variation mécanique de fréquences est grande mais la sensibilité est faible.

A titre d'exemple, si le diamètre du piston 14 est pris arbitrairement égal à l'unité, et que celui du manchon 17 est égal à 1,6, on obtient les résultats suivants: réglage de 94 à 94,4 GHz, ou réglage de 95 à 95,4 GHz, pour une puissance de l'émetteur supérieure à 100 milli/W, avec une variation de puissance dans la bande d'accord de l'ordre de 0,6 db.

La diode oscillatrice seule, c'est-à-dire sans diode à capacité variable, fournit environ 130 milli/W à 94 GHz, ce qui montre les faibles pertes introduites par le système d'accord mécanique selon l'invention.

Le fait de disposer d'un système d'accord mécanique continu n'empêche pas la possibilité, qui n'a pas été représentée sur la fig. 3, de disposer également d'un système d'accord électronique tel qu'il est représenté en fig. 2, les deux systèmes sont complémentaires ou peuvent opérer chacun séparément.

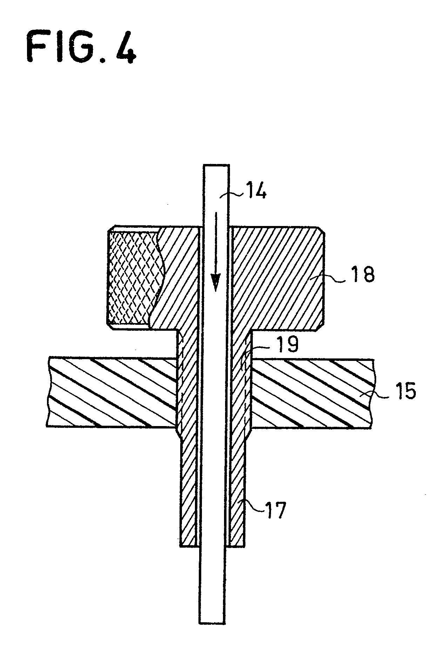

La fig. 4 représente le moyen de réglage continu d'acord, selon l'invention. Seule la partie intéressante du point de vue mécanique a été représentée sur cette fig. 4, vue en coupe au niveau de l'absorbant hyperfréquence 15 qui maintient et centre ce système par rapport à la cavité.

Le piston 14 est poussé au contact du disque métallique 5 par des moyens non représentés sur cette fig. 4 et qui peuvent être soit un petit ressort hélicoïdal, soit une lame de ressort, soit encore un filet de vis qui s'appuie sur un étrier ou tout autre système non représenté sur cette figure. Il est important de ne pas établir de court-circuit et que les ressorts ou l'étrier soient isolés par rapport au corps 11 de la cavité.

Autour du piston 14, glisse à contact doux une pièce comportant d'une part le manchon 17 qui permet de faire varier le diamètre de la tige de polarisation de la diode à capacité variable, d'autre part une molette 18 d'un diamètre suffisant pour pouvoir être réglée avec les doigts ou avec un petit instrument tel qu'une brucelle ou une petite clé, et enfin un filetage 19, dont le pas de vis est suffisamment fin pour permettre un réglage précis de la postion du manchon 17 par rapport au piston 14. Le filetage 19 s'appuie sur le matériau absorbant les hyperfréquences 15, ou peut aussi bien s'appuyer lui aussi sur un étrier qui serait extérieur à la cavité, mais dans ce cas il est nécessaire de prendre les mêmes précautions d'isolation de l'étrier que celles qui ont été citées à propos du ressort qui appuie sur le piston 14.

D'autres systèmes de réglage de positionnement d'un manchon 17 par rapport à un piston 14, peuvent être utilisés sans pour autant sortir du domaine de l'invention. Ces systèmes ressortent des connaissances en mécanique et sont à la portée de l'homme de l'art.

Cet émetteur accordable de façon continue et fine par des moyens mécaniques est essentiellement appliqué pour des autodirecteurs, ou pour des oscillateurs locaux à diodes Gunn ou Impatt, et de façon plus générale dans le domaine de l'émission de micro-ondes à fréquence millimétrique, sans que cette précision apporte une limitation au domaine de l'invention qui s'applique de façon plus générale aux hyperfréquences. Elle est d'ailleurs précisée par les revendications ci-après.

## Revendications

1. Oscillateur accordable en fréquence, constitué par une diode oscillatrice et une diode à capacité variable assemblées en un composant unitaire (10) monté à l'intérieur d'une cavité (11), la masse électrique de l'oscillateur étant prise sur l'embase (3) de la diode oscillatrice (1), la tension de polarisation de la diode oscillatrice étant amenée au moyen d'un premier piston latéral (12), isolé (13), qui s'appuie sur un premier disque métallique (7) intercalé entre les deux diodes et en contact électrique avec elles, la tension de polarisation de la diode à capacité variable (2) étant amenée au moyen d'un second piston (14) isolé (15) qui s'appuie sur un second disque métallique (5) qui sert d'embase à la diode à capacité variable (2), cet oscillateur étant caractérisé en ce qu'il est accordable de façon continue par un moyen mécanique constitué par un manchon métallique (17), mobile autour du second piston (14) avec lequel il est en contact mécanique doux, le déplacement de ce manchon (17) le long du piston (14), engendrant une modification du diamètre de cette connexion électrique, engendre une modification de l'inductance en série avec les diodes (1 et 2) et permet le réglage de la fréquence centrale d'oscillation.

2. Oscillateur accordable en fréquence selon la revendication 1, caractérisé en ce que le moyen mécanique (17) d'accord continu est complémentaire de moyens mécaniques d'accord discontinu, tels que l'adaptation radiale d'impédance par adaptation du diamètre du premier disque métallique (7) et adaptation des dimensions internes de la cavité (11) au moyen d'un anneau (16) disposé autour de l'embase (3) de la diode oscillatrice (1).

3. Oscillateur accordable en fréquence selon la revendication 1, caractérisé en ce que le moyen mécanique (17) d'accord continu est complémentaire de moyens électriques d'accord, par variation de la tension ($V_2$) de polarisation de la diode à capacité variable (2).

4. Oscillateur accordable en fréquence selon la revendication 1, caractérisé en ce que le moyen mécanique d'accord continu est constitué par un manchon métallique (17), comportant une partie extérieure à la cavité (11), cette partie (18), coulissant le long d'une portée cylindrique du second piston (14), étant moletée ou à pans en vue de permettre le déplacement du manchon (17) par l'intermédiaire d'un filetage (19) qui porte sur un isolant (15) électrique.

5. Procédé d'accord mécanique d'un oscillateur selon l'une quelconque des revendications 1 à 4, caractérisé en ce que la fréquence centrale d'oscillation du composant unitaire (10) est obtenue en déplaçant un manchon métallique (17), mobile autour du second piston (14), lequel amène la tension de polarisation ($V_2$) de la diode à capacité variable (2).

**Patentansprüche**

1. Frequenzabstimmbarer Oszillator, bestehend aus einer Schwingdiode und einer Diode veränderlicher Kapazität, die als einstückiger Bauteil (10) gefertigt sind, welcher innerhalb einer Ausnehmung (11) angeordnet ist, wobei die elektrische Masse durch den Sockel (3) der Schwingdiode (1) gegeben ist und die Polarisierungsspannung der Schwingdiode durch einen ersten seitlichen isolierten (13) Kolben (12) zugeleitet wird, der sich auf einer ersten Metallscheibe (7) abstützt, welche zwischen den beiden Dioden eigesetzt und mit denselben elektrisch verbunden ist, während die Polarisierungsspannung der Diode veränderlicher Kapazität (2) durch einen isolierten (15) zweiten Kolben (14) zugeleitet wird, der sich auf einer als Sockel der Diode veränderlicher Kapazität (2) dienenden zweiten Metallscheibe (5) abstützt, dadurch gekennzeichnet, dass der Oszillator kontinuierlich abstimmbar ist mit Hilfe eines mechanischen Mittels, das durch eine Metallhülse (17) gebildet wird, welche um den zweiten Kolben (14) beweglich angeordnet ist und mit demselben in sanfter mechanischer Berührung steht, wobei die eine Veränderung des Durchmessers dieses elektrischen Kontakts hervorrufende Bewegung dieser Hülse (17) längs des Kolbens eine Veränderung der mit den Dioden (1 und 2) in Reihe geschalteten Induktanz bewirkt und das Einstellen der mittleren Schwingungsfrequenz gestattet.

2. Frequenzabstimmbarer Oszillator nach Anspruch 1, dadurch gekennzeichnet, dass das mechanische Mittel (17) zur kontinuierlichen Abstimmung mechanische Mittel zur diskontinuierlichen Abstimmung vervollständigt, z.B. zwecks radialer Anpassung der Impedanz durch Anpassung des Durchmessers der ersten Metallscheibe (7) und Anpassung der Innenabmessung der Ausnehmung (11) vermittels eines um den Sockel (3) der Schwingdiode (1) umgebenden Ringes (16).

3. Frequenzabstimmbarer Oszillator nach Anspruch 1, dadurch gekennzeichnet, dass das mechanische Mittel (17) zur kontinuierlichen Abstimmung elektrische Abstimmittel vervollständigen, die die Abstimmung durch Veränderung der Polarisationsspannung ($V_2$) der Diode veränderlicher Kapazität (2) bewirken.

4. Frequenzabstimmbarer Oszillator nach Anspruch 1, dadurch gekennzeichnet, dass das mechanische Mittel zur kontinuierlichen Abstimmung aus einer Metallhülse (17) besteht, die einen ausserhalb der Ausnehmung (11) liegenden, längs einer zylindrischen Stützfläche des zweiten Kolbens (14) verschiebbaren und gerändelten bzw. gekanteten Abschnitt (18) aufweist, derart, dass die Hülse (17) vermittels eines auf einem elektrisch isolierenden Material (15) angeordneten Gewindes (19) verstellbar ist.

5. Verfahren zur mechanischen Abstimmung eines Oszillators nach einem der Ansprüche 1 bis 4, dadurch gekennzeichnet, dass die mittlere Schwingungsfrequenz des einstückigen Bauteils (10) durch Verstellen einer um den zweiten Kolben (14) herum beweglichen Metallhülse (17) erzielt wird, welch letztere die Polarisationsspannung ($V_2$) der Diode veränderlicher Kapazität (2) heranführt.

**Claims**

1. Frequency-tunable oscillator, constituted by an oscillating diode and a variable-capacity diode assembled to form one unitary component (10) mounted in a recess (11), the electrical mass of the oscillator being taken from the base (3) of the oscillating diode (1), the polarisation voltage of the oscillating diode being supplied through a first lateral piston (12) which is isolated (13) and rests on a first metallic disc (7) interposed between the two diodes and electrically connected with said diodes, the polarisation voltage of the variable-capacity diode (2) being supplied through a second piston (14) which is isolated (15) and rests on a second metallic disc (5) constituting the base of the variable-capacity diode (2), said oscillator being characterized in that it is continuously tunable by a mechanical means constituted by a metallic sleeve (17) movable about the second piston (14) with which it is held in soft mechanical contact, the displacement of said sleeve (17) along the piston (14), while causing the diameter of this electric connection to vary, results in trying the inductance in series with the diodes (1 and 2) and allows the mean oscillation frequency to be adjusted.

2. Frequency-tunable oscillator according to claim 1, characterized in that the mechanical means (17) for continuously tuning is complementary of mechanical means for discontinuously tuning, such as by radial impedance adaptation through adaptation of the diameter of the first metallic disc (7) and adaptation of the internal dimensions of the recess (11) by means of a ring (16) mounted so as to surround the base (3) of the oscillating diode (1).

3. Frequency-tunable oscillator according to claim 1, characterized in that the mechanical means (17) for continuously tuning is complementary of electrical means for tuning by varying the polarisation voltage ($V_2$) of the variable-capacity diode (2).

4. Frequency-tunable oscillator according to claim 1, characterized in that the mechanical means for continuously tuning is constituted by a metallic sleeve (17) comprising a portion located outside of the recess (11), while said portion (18), which slides along cylindrical bearing surface of the second piston (14), is knurled or provided with planar side faces so as to allow the sleeve (17) to be displaced by means of a screw thread (19) supported by an electrically isolating material (15).

5. Method of mechanically tuning an oscillator according to any one of claims 1 to 4, characterized in that the mean oscillation frequency of the unitary component (10) is obtained by displacing a metallic sleeve (17) which is movable about the second piston (14) supplying the polarisation voltage ($V_2$) of the variable-capacity diode (2).

# FIG.1

# FIG.2

# FIG.3

# FIG. 4